# EUROPÄISCHE PATENTANMELDUNG

(11) **EP 3 789 903 A1**
(43) Veröffentlichungstag der Anmeldung: **10.03.2021**
(21) Anmeldenummer: 19195420.5
(22) Anmeldetag: 04.09.2019
(51) Int. Cl.: G06F 30/20, G06K 9/00

(54) **VERFAHREN UND VORRICHTUNG ZUR GENERIERUNG EINES BELEGUNGSPLANS FÜR EIN BAUWERK**

(71) Anmelder: Siemens Schweiz AG, 8047 Zürich (CH)
(72) Erfinder: KLEIN, Wolfram, 85579 Neubiberg (DE); MAYER, Hermann Georg, 83209 Prien am Chiemsee (DE)
(74) Vertreter: Maier, Daniel Oliver

(57) **Zusammenfassung**

Die Erfindung betrifft ein computerimplementiertes Verfahren zur Generierung eines Belegungsplans für ein Bauwerk, wobei ein computergestütztes Bauwerksmodells (BIM) und erste Sensordaten (D1) mindestens eines Sensors eingelesen werden, wobei die ersten Sensordaten (D1) zeit- und/oder positionsabhängige Auslastungsinformation in Bezug auf mindestens einen Teil des Bauwerks umfassen. Anhand des computergestützten Bauwerksmodells (BIM) wird mindestens ein weiterer Teil des Bauwerks selektiert und zweite Sensordaten (D2) mittels einer computergestützten Simulation für den selektierten Teil des Bauwerks generiert, wobei die zweiten Sensordaten (D2) zeit- und/oder positionsabhängige Auslastungsinformation in Bezug auf den selektierten Teil des Bauwerks umfassen. Aus einer Analyse der ersten Sensordaten (D1) und/oder der zweiten Sensordaten (D2) hinsichtlich der jeweiligen Auslastungsinformation wird eine Belegungsinformation für den jeweiligen Teil des Bauwerks für ein vorgegebenes Zeitintervall oder einen vorgegebenen Zeitpunkt abgeleitet und die jeweilige Belegungsinformation zur Generierung eines Belegungsplans für das Bauwerk ausgegeben.

## Beschreibung

Die Erfindung betrifft ein computerimplementiertes Verfahren und eine Vorrichtung zur Generierung eines Belegungsplans eines Bauwerks. Des Weiteren ist die Erfindung auf ein Computerprogrammprodukt und einen computerlesbaren Datenträger gerichtet.

Für eine Planung, Ausführung und/oder Bewirtschaftung von Gebäuden und anderen Bauwerken ist die Methode der Bauwerksmodellierung (engl. Building Information Modeling, kurz: BIM) bekannt. Mithilfe von Software können relevanten Bauwerksdaten digital modelliert, kombiniert und erfasst werden. Das Bauwerk kann insbesondere mittels eines Computermodells modelliert und visualisiert werden.

Insbesondere für komplexe Gebäude ist die Belegung von Räumen bzw. Gebäudeteilen durch Personen oft schwierig zu ermitteln. Bisherige Belegungspläne werden in der Regel lediglich in der Entwurfsphase eines Gebäudes erstellt und werden anschließend meist nicht aktualisiert. In der Regel existiert lediglich ein statischer Belegungsplan, der beispielsweise eine maximale Belegung angibt. Eine detaillierte Aufschlüsselung der tatsächlichen, zeitabhängigen Auslastung ist beispielsweise für eine effiziente Evakuierung oder zur Verbesserung der Energieeffizienz eines Gebäudes wünschenswert.

Es ist daher die Aufgabe der Erfindung, eine einfache Möglichkeit zu schaffen, eine zeitabhängige Auslastung eines Gebäudes zu ermitteln.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein computerimplementiertes Verfahren zur Generierung eines Belegungsplans für ein Bauwerk, umfassend die Verfahrensschritte:
- Einlesen eines computergestützten Bauwerksmodells des Bauwerks,
- Einlesen erster Sensordaten mindestens eines Sensors, wobei die ersten Sensordaten eine zeit- und/oder positionsabhängige Auslastungsinformation in Bezug auf mindestens einen Teil des Bauwerks umfassen,
- Selektieren mindestens eines weiteren Teils des Bauwerks anhand des computergestützten Bauwerksmodells,
- Generieren zweiter Sensordaten mittels einer computergestützten Simulation für den selektierten Teil des Bauwerks, wobei die zweiten Sensordaten eine zeit- und/oder positionsabhängige Auslastungsinformation in Bezug auf den selektierten Teil des Bauwerks umfassen,
- Ableiten einer Belegungsinformation für den jeweiligen Teil des Bauwerks für ein vorgegebenes Zeitintervall oder einen vorgegebenen Zeitpunkt aus einer Analyse der ersten Sensordaten und/oder der zweiten Sensordaten hinsichtlich der jeweiligen Auslastungsinformation in dem vorgegebenen Zeitintervall oder zu dem vorgegebenen Zeitpunkt
   und
- Ausgeben der jeweiligen Belegungsinformation zur Generierung eines Belegungsplans für das Bauwerk.

Gemäß einem zweiten Aspekt betrifft die Erfindung eine Vorrichtung zur Generierung eines Belegungsplans für ein Bauwerk, umfassend mindestens einen Prozessor zur Ausführung der Schritte des erfindungsgemäßen Verfahrens.

Es ist ein Vorteil der vorliegenden Erfindung, dass durch eine sensorbasierte Erfassung einer Auslastung von mindestens einem Teil des Bauwerks, sowohl mittels realer als auch mittels virtueller Sensoren, die Belegung eines Bauwerks detailliert bestimmt werden kann. Dies ermöglicht insbesondere eine Nutzung, eine Evakuierung oder einen Energieverbrauch der jeweiligen Teile des Bauwerks zu verbessern.

Dazu wird zunächst das computergestützte Bauwerksmodells des Bauwerks eingelesen, welches insbesondere Bauwerksdaten umfasst. Das computergestützte Bauwerksmodell kann auch als digitales Bauwerksmodell, insbesondere als "Building Information Model", kurz BIM, bezeichnet werden. Das computergestützte Bauwerksmodell wird vorzugsweise als Datei bereitgestellt.

Mindestens ein realer Sensor des Bauwerks erfasst erste Sensordaten, die zeit- und/oder positionsabhängige Auslastungsinformation eines Teils des Bauwerks umfassen. Unter "Auslastungsinformation" kann insbesondere eine vom Sensor detektierte zeitabhängige Personenanzahl verstanden werden. Außerdem kann unter "Auslastungsinformation" ein Wert einer Messgröße verstanden werden, von dem eine Personenanzahl ableitbar ist, wie z.B. eine durch einen CO2-Sensor gemessene, zeitabhängige CO2-Konzentration in einem Raum. Die ersten, realen Sensordaten werden durch zweite, virtuelle Sensordaten ergänzt. Mittels einer Auswertung der realen und/oder virtuellen Sensordaten kann für einen jeweiligen Teil eines Bauwerks, z.B. eines Raums eines Gebäudes, eine zeitabhängige Personenbelegung ermittelt werden. Ein Belegungsplan umfasst insbesondere mindestens eine Belegungsinformation, die einem Teil des Bauwerks zugeordnet ist. Unter "Belegungsinformation" kann insbesondere eine abgeleitete oder ermittelte Personenanzahl verstanden werden, die aus mehr als einer Auslastungsinformation abgeleitet wird. Beispielsweise umfasst eine Belegungsinformation gemittelte Sensordaten verschiedener realer und/oder virtueller Sensoren eines Raums.

Insbesondere können für einen Teil des Bauwerks, für den keine oder unzureichende erste Sensordaten vorliegen, mittels einer computergestützten Simulation virtuelle Sensordaten erzeugt werden, so dass anschließend vorzugsweise für alle vorgegebenen Teile des Bauwerks Sensordaten vorliegen und daraus ein vollständiger Belegungsplan für das Bauwerk erzeugt werden kann. Die computergestützte Simulation für den selektierten Teil des Bauwerks wird mittels eines Simulationsmodells für das Bauwerk oder zumindest für den entsprechenden Teil des Bauwerks durchgeführt, wobei das Simulationsmodell vorzugsweise die Positionen der jeweils im oder am Bauwerk vorhandenen Sensoren umfasst und das auf dem Bauwerksmodells basiert, d.h. insbesondere Bauwerksdaten umfasst. Somit kann eine Auslastung der jeweiligen Bauwerksteile unter Berücksichtigung der spezifischen Eigenschaften des jeweiligen Teils des Bauwerks extrapoliert werden.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen, vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "computergestützt" oder "rechnergestützt" oder ähnliches kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU) handeln.

In einer vorteilhaften Ausführungsform des computerimplementierten Verfahrens kann die computergestützte Simulation auf Basis der ersten Sensordaten ausgeführt werden.

Um die zweiten Sensordaten zu generieren, kann insbesondere die computergestützte Simulation ausgehend von den ersten Sensordaten ausgeführt werden. Derart können beispielsweise zweite Sensordaten für einen Teil des Bauwerks in Abhängigkeit von den ersten Sensordaten eines anderen Teils des Bauwerks, z.B. eines angrenzenden Raums, generiert werden. Somit kann eine Auslastung mittels der gemessenen Personenanzahl in anderen Teilen des Bauwerks bestimmt werden.

In einer vorteilhaften Ausführungsform des computerimplementierten Verfahrens kann die computergestützte Simulation eine computergestützte Personenstromsimulation für den selektierten Teil des Bauwerks sein.

Es kann auf Basis eines computergestützten Simulationsmodells für das Bauwerk eine Personenstromsimulation ausgeführt werden, um die Belegung durch Personen in einem selektierten Teil des Bauwerks zu ermitteln, vorherzusagen und/oder zu extrapolieren. Das computergestützte Simulationsmodell kann vorzugsweise eine Personenanzahl, eine personenspezifische Geschwindigkeit, eine personenspezifische Bewegungsrichtung und/oder ein personenspezifisches Ziel im Bauwerk umfassen.

In einer weiteren Ausführungsform des computerimplementierten Verfahrens kann der Belegungsplan auf Basis aktueller erster Sensordaten und zu einem vorgegebenen Zeitpunkt aktualisiert generiert werden.

Dies hat den Vorteil, dass ein Belegungsplan nicht statisch festgelegt ist, sondern zeitabhängig aktualisiert werden kann.

In einer weiteren Ausführungsform des computerimplementierten Verfahrens können die ersten Sensordaten mit einem dem mindestens einen Sensor zugeordneten Zuverlässigkeitswert gekennzeichnet werden.

Ein Zuverlässigkeitswert kann beispielsweise eine Detektionsgenauigkeit und/oder eine Sensitivität eines Sensors beschreiben. Außerdem kann ein Zuverlässigkeitswert einen Aktivitätsstatus eines Sensors, z.B. Batteriestatus, beschreiben. Die ersten Sensordaten können insbesondere in Abhängigkeit des zugeordneten Zuverlässigkeitswerts gewichtet werden.

In einer weiteren Ausführungsform des computerimplementierten Verfahrens kann für den mindestens einen weiteren selektierten Teil des Bauwerks eine Belegungsinformation mittels einer Plausibilitätsanalyse abgeleitet werden.

Eine Plausibilitätsanalyse umfasst beispielsweise eine Analyse oder Abschätzung basierend auf ersten Sensordaten, um Auslastungsinformation für einen selektierten Teil des Bauwerks zu ermitteln. Die Plausibilitätsanalyse kann insbesondere zusätzlich oder alternativ zu der computergestützten Simulation für einen jeweiligen Teil des Bauwerks ausgeführt werden.

In einer vorteilhaften Ausführungsform des computerimplementierten Verfahrens können die ersten Sensordaten und/oder die zweiten Sensordaten zumindest teilweise in das computergestützte Bauwerksmodell eingefügt werden.

Die erfassten bzw. generierten Sensordaten können beispielsweise als erweiterte Information bzw. Attribut in das computergestützte Bauwerksmodell eingefügt werden, so dass beispielsweise die entsprechende Auslastungsinformation zentral in einer Datei erfasst wird. Insbesondere können die jeweiligen Sensordaten mit einer im Bauwerksmodell integrierten Positionsinformation des jeweiligen Sensors verknüpft werden.

In einer vorteilhaften Ausführungsform des computerimplementierten Verfahrens kann die jeweilige Belegungsinformation und/oder der Belegungsplan in das computergestützte Bauwerksmodell eingefügt werden.

Die jeweilige Belegungsinformation und/oder der entsprechende Belegungsplan können beispielsweise als erweiterte Information bzw. Attribut in das computergestützte Bauwerksmodell eingefügt werden. Demnach kann eine Belegungsinformation und/oder ein Belegungsplan zu einem vorgegebenen Zeitpunkt abgespeichert und anschließend abgerufen werden.

In einer weiteren Ausführungsform des computerimplementierten Verfahrens kann der generierte Belegungsplan an einen Nutzer zur Optimierung der Auslastung des Bauwerks und/oder zur Steuerung einer Gebäudetechnik in Abhängigkeit des Belegungsplans ausgegeben werden.

Des Weiteren betrifft die Erfindung ein Computerprogrammprodukt, das direkt in einen programmierbaren Computer ladbar ist, umfassend Programmcodeteile, die bei der Ausführung des Programms durch einen Prozessor diesen veranlassen, das Verfahren und/oder zumindest teilweise die Schritte eines Verfahrens auszuführen und ein computerlesbares Speichermedium mit einem erfindungsgemäßen Computerprogrammprodukt.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele des erfindungsgemäßen Verfahrens und der erfindungsgemäßen Vorrichtung sind in den Zeichnungen beispielhaft dargestellt und werden anhand der nachfolgenden Beschreibung näher erläutert. Es zeigen:
- Fig. 1:: ein Ablaufdiagramm eines erfindungsgemäßen Verfahrens;
- Fig. 2:: eine schematische Darstellung eines erfindungsgemäßen Verfahrens; und
- Fig. 3:: eine schematische Darstellung einer erfindungsgemäßen Vorrichtung.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

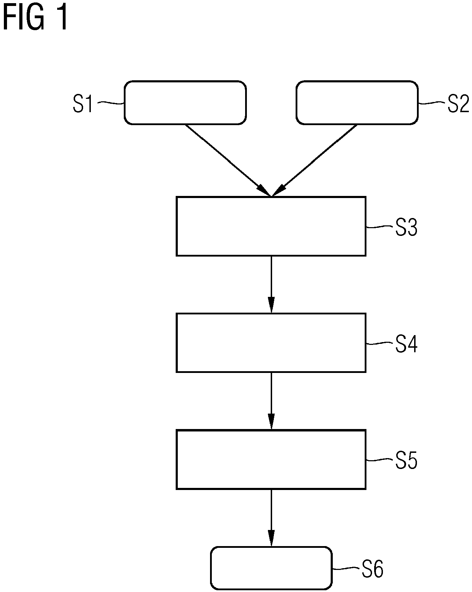

Figur 1 zeigt ein Ablaufdiagramm eines erfindungsgemäßen computerimplementierten Verfahrens zur Generierung eines Belegungsplans für ein Bauwerk. Ein Belegungsplan soll derart generiert werden, dass vorzugsweise zu einem vorgegebenen Zeitpunkt und/oder für ein vorgegebenes Zeitintervall die Belegung bzw. Nutzung von Teilen des Bauwerks durch Personen abgebildet wird.

Es wird im ersten Schritt S1 des Verfahrens ein computergestütztes Bauwerksmodell des Bauwerks eingelesen. Das computergestützte Bauwerksmodell wird vorzugsweise in einem Format, das für Building Information Modelling kompatibel ist, bereitgestellt. Es umfasst insbesondere Bauwerksdaten und weitere Informationen, die das Bauwerk betreffen. Es sind insbesondere alle Teile des Bauwerks im Bauwerksmodell erfasst, so dass deren Zuordnung der Position und z.B. Raumgröße innerhalb des Bauwerks und/oder Raumnutzung anhand des Bauwerksmodells ermittelbar ist. Vorzugsweise sind Positionen und/oder Typinformation von realen Sensoren, die sich im oder am Bauwerk befinden, im Bauwerksmodell hinterlegt. So ist beispielsweise eine Zuordnung, welcher Sensor sich in welchem Raum befindet aus dem Bauwerksmodell ermittelbar.

Außerdem werden im Schritt S2 erste Sensordaten mindestens eines realen Sensors, der sich in oder am Bauwerk befindet, eingelesen. Vorzugsweise werden von mehr als einem Sensor erste Sensordaten eingelesen. Der Sensor kann beispielsweise eine Kamera, ein Personenzählsensor, ein Infrarotsensor, Temperatursensor, ein CO2-Sensor oder ähnliches sein. Mittels des Sensors wird eine zeit- und/oder positionsabhängige Auslastungsinformation eines Teils des Bauwerks, der vom Sensor erfasst wird, ermittelt. In anderen Worten, abhängig von der Position des Sensors in oder am Bauwerk kann für einen vorgegebenen Zeitpunkt oder Zeitraum eine Personenanzahl für einen entsprechenden Teil des Bauwerks ermittelt werden. Erste Sensordaten können folglich beispielsweise einen zeitlichen Verlauf einer Personenanzahl an einem, von der Position bzw. Detektionsbereichs des Sensors definierten Ort des Bauwerks, umfassen. Außerdem oder alternativ können erste Sensordaten Information umfassen, von der eine Personenanzahl oder eine Abschätzung einer Personenanzahl ableitbar ist, wie z.B. die CO2-Konzentration in einem Raum oder die Aktivität eines Bewegungsmelders.

Außerdem kann der mindestens eine Sensor durch einen Zuverlässigkeitswert gekennzeichnet sein. Der Zuverlässigkeitswert kann außerdem den ersten Sensordaten zugeordnet werden. Ein Zuverlässigkeitswert kann beispielsweise angeben, dass die Erfassung einer Personenanzahl mittels eines CO2-Sensors mit einer größeren Ungenauigkeit behaftet ist als die Erfassung mittels einer Videokamera. Eine Videokamera wiederum kann beispielsweise Personen, die sich nicht im Sichtfeld befinden, nicht erfassen.

Im nächsten Schritt S3 wird anhand des computergestützten Bauwerksmodells ein weiterer Teil des Bauwerks selektiert. Vorzugsweise ist die Positionsinformation der im oder am Bauwerk vorhandenen Sensoren im computergestützten Bauwerksmodell gespeichert, so dass beispielsweise ein Teil des Bauwerks selektiert werden kann, der nicht oder nicht ausreichend von mindestens einem Sensor erfasst wird.

Für diesen selektierten Teil des Bauwerks wird im Schritt S4 eine computergestützte Simulation auf Basis eines computergestützten Simulationsmodells für das Bauwerks, wie z.B. eine Personenstromsimulation, ausgeführt. Mittels der computergestützten Simulation werden zweite Sensordaten für den selektierten Teil des Bauwerks generiert. Die zweiten Sensordaten können auch als virtuelle Sensordaten oder als Softsensoren bezeichnet werden. Die zweiten Sensordaten umfassen zeit- und/oder positionsabhängige Auslastungsinformation in Bezug auf den selektierten Teil des Bauwerks. Vorzugsweise wird die computergestützte Simulation ausgehend von den ersten, realen Sensordaten ausgeführt. Alternativ können die ersten, realen Sensordaten auch als Rand- oder Nebenbedingung für die computergestützte Simulation genutzt werden, wie z.B. eine gemessene Personenanzahl an einem Ein- bzw. Ausgang des Bauwerks.

Im nächsten Schritt S5 wird auf Basis der ersten Sensordaten und/oder der zweiten Sensordaten mindestens eine Belegungsinformation für einen jeweiligen Teil des Bauwerks abgeleitet. Dazu werden die ersten und/oder die zweiten Sensordaten hinsichtlich der jeweiligen zeit- und/oder positionsabhängigen Auslastungsinformation ausgewertet. Bei der Auswertung kann die Gewichtung der jeweiligen Sensordaten aufgrund eines jeweiligen Zuverlässigkeitswert berücksichtigt werden.

Zum Beispiel wird für ein vorgegebenes Zeitintervall die Auslastungsinformation mehrerer realer Sensoren eines Raums zeitlich gemittelt, so dass sich eine zeitabhängige Belegungsinformation für diesen Raum ergibt. Dabei können beispielsweise Sensordaten eines Sensor mit einem eingeschränkten Detektionsbereich heruntergewichtet werden.

Als weiteres Beispiel kann ein Zugangskontrollsystem für einen Teil des Bauwerks ein Drehkreuz umfassen, welches die Anzahl der passierenden Personen in einem vorgegebenen Zeitraum erfasst. Aus dieser Messgröße kann beispielsweise eine Personenanzahl, der sich in dem entsprechenden Teil des Bauwerks aufhaltenden Personen, abgeleitet werden.

Im nächsten Schritt S6 wird die mindestens eine Belegungsinformation ausgegeben. Vorzugsweise wird für mehr als einen Teil des Bauwerks, wie z.B. mehrere Räume, eine Belegungsinformation für einen vorgegebenen Zeitpunkt und/oder Zeitraum ermittelt und kombiniert als Belegungsplan ausgegeben. Der Belegungsplan wird aus der mindestens einer Belegungsinformation eines Bauwerksteils generiert. Beispielsweise werden Belegungsinformationen mehrerer Teile des Bauwerks in Abhängigkeit einer jeweiligen Ortsinformation des jeweiligen Bauwerksteils zusammengefügt und derart der Belegungsplan generiert. Der Belegungsplan umfasst somit mindestens eine zeit- und ortsabhängige Belegungsinformation. Der generierte Belegungsplan kann über eine Benutzerschnittstelle an einen Nutzer zur Optimierung der Auslastung des Bauwerks und/oder zur Steuerung oder Management einer Gebäudetechnik ausgegeben werden. Beispielsweise kann mittels des zeitabhängigen Belegungsplans eine Energieeffizienz des Bauwerks optimiert werden. Ein derart generierter Belegungsplan kann beispielsweise für ein vorgegebenes Zeitintervall gültig sein. Dies ermöglicht beispielsweise einen Vergleich mit Belegungsplänen zu anderen Zeitpunkten oder für andere Zeitintervalle. Mit dem Verfahren können aktuelle Belegungspläne für einen Teil und/oder für das gesamte Bauwerk automatisch erstellt, aktualisiert und/oder ausgewertet werden. Insbesondere kann lediglich für einen Teil des Bauwerks eine Belegungsinformation aktualisiert werden und für die Generierung des Belegungsplans bereitgestellt werden.

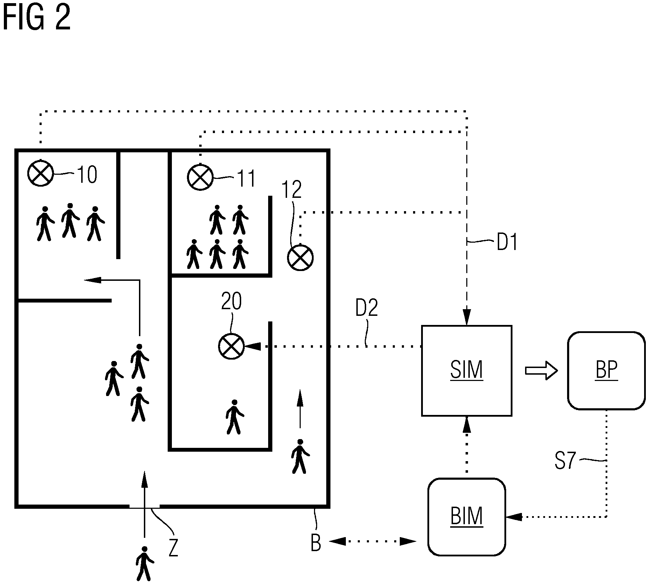

Figur 2 zeigt schematische eine Ausführungsform des erfindungsgemäßen Verfahrens. Es ist eine Draufsicht eines Bauwerks B, d.h. eine zweidimensionale orthogonale Projektion der räumlichen Gestalt des Bauwerks B dargestellt. Das Bauwerk B umfasst mehrere Räume. Durch einen Zugang Z können Personen das Bauwerk betreten oder verlassen und sich in den jeweiligen Räumen des Bauwerks aufhalten. Es soll ein Belegungsplan BP für ein vorgegebenes Zeitintervall erstellt werden, um beispielsweise die Nutzung der jeweiligen Räume zeitabhängig zu bestimmen. Dazu werden zunächst erste Sensordaten D1 von realen Sensoren 10, 11, 12, die sich im Bauwerk B befinden, erfasst. Die Sensordaten D1 umfassen beispielsweise Zeitreihen von sensorspezifischen Messgrößen.

Außerdem wird ein computergestütztes Bauwerksmodell BIM des Bauwerks B bereitgestellt, das Bauwerksdaten des Bauwerks B umfasst, wie z.B. Räume, Raumgrößen, Stockwerke etc.. Vorzugsweise sind die Sensortypen und/oder Sensorpositionen der realen Sensoren 10, 11, 12 im computergestützten Bauwerksmodell BIM gespeichert, so dass die Position eines Sensors relativ zum Bauwerk ermittelt werden kann.

Anhand des computergestützten Bauwerksmodells BIM wird mindestens ein Teil des Bauwerks selektiert. Vorzugsweise wird ein Teil des Bauwerks, z.B. ein Raum, selektiert, der nicht von einem Sensor erfasst wird, d.h. für den keine realen Sensordaten vorliegen. Die Selektion kann insbesondere auf Basis der im Bauwerksmodell gespeicherten Sensorpositionen erfolgen. Für diesen mindestens einen selektierten Teil des Bauwerks und/oder das mehrere Teile des Bauwerks werden mittels einer computergestützten Simulation SIM virtuelle Sensordaten D2 generiert. Vorzugsweise wird eine Personenstromsimulation genutzt, so dass die virtuellen Sensordaten zeit- und/oder positionsabhängige Auslastungsinformation für den selektierten Teil des Bauwerks aufweisen. In anderen Worten, basierend auf den bauwerksspezifischen Informationen aus dem computergestützten Bauwerksmodell BIM wird eine computergestützte Simulation SIM für mindestens einen Teil des Bauwerks B durchgeführt und derart mindestens ein Softsensor 20 generiert. Somit kann für einen Teil des Bauwerks, für welchen beispielsweise unzureichende reale Sensordaten vorliegen, virtuelle Sensordaten D2 erzeugt werden.

Die ersten Sensordaten D1 und die zweiten Sensordaten D2 werden anschließend hinsichtlich der Auslastung des Bauwerks oder zumindest eines Teils des Bauwerks analysiert.

Die Sensordaten D1, D2 können beispielsweise nach Ort oder Raum, Tageszeit oder Wochentag strukturiert und/oder historisch ausgewertet werden. Beispielsweise können die Sensordaten von zwei oder mehreren Räumen miteinander verglichen werden, wie z.B. entweder von benachbarten Räumen oder Räumen desselben Typs. Es kann auch die minimale oder maximale Belegung eines Zeitraums und/oder eines definierten Teils des Bauwerks, wie z.B. ein Stockwerk, ermittelt werden. Außerdem kann ein Vergleich der Sensordaten mit Soll- oder Durchschnittswerten einer Belegungszahl durchgeführt werden, wie z.B. zur Bestimmung einer Abweichung von Soll- bzw. Durchschnittswerten. Damit können Räume identifiziert werden, die besonders stark oder wenig genutzt werden. Abhängig vom Analyseergebnis kann außerdem eine Meldung ausgegeben werden, wenn z.B. eine vorgegebene maximale Personenzahl überschritten wird, ein Raum von zu wenigen Personen genutzt wird oder wenn ein Raum falsch bezeichnet ist.

Aus der Analyse der Sensordaten D1, D2, kann für einen jeweiligen Teil des Bauwerks eine zeitabhängige Belegungsinformation abgeleitet und ausgegeben. Aus den jeweiligen Belegungsinformationen wird ein Belegungsplan BP generiert, so dass der Belegungsplan BP vorzugsweise Belegungsinformationen von mehr als einem Teil des Bauwerks umfasst. Der Belegungsplan kann an einen Nutzer ausgegeben werden und zur Optimierung der Nutzung des Bauwerks angewandt werden. Der Belegungsplan BP und/oder die jeweilig Belegungsinformation kann außerdem in das computergestützte Bauwerksmodell BIM integriert werden, S7. Ebenso können die ersten Sensordaten D1 und/oder die zweiten Sensordaten D2 zumindest teilweise, z.B. zeitliche Mittelwerte der Sensordaten eines Raums, in das Bauwerksmodell BIM integriert werden.

Alternativ oder zusätzlich kann für einen selektierten Teil des Bauwerks B mittels einer Plausibilitätsanalyse eine Belegungsinformation abgeleitet werden. Beispielsweise kann anhand von mindestens einem Teil der ersten Sensordaten D1 und anhand von Bauwerksdaten aus dem Bauwerksmodell BIM abgeschätzt werden, wie viele Personen sich im selektierten Teil des Bauwerks befinden.

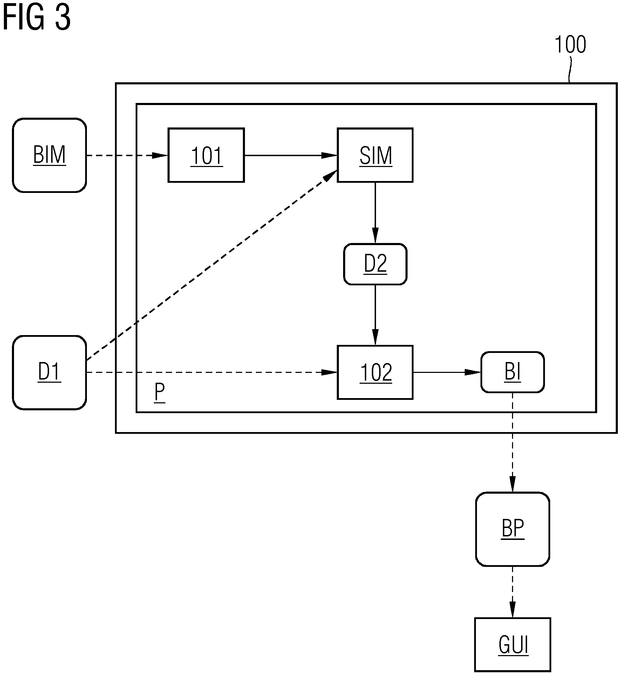

Figur 3 zeigt eine schematische Darstellung einer Vorrichtung 100 zur Generierung eines Belegungsplans für ein Bauwerk. Die Vorrichtung 100 umfasst mindestens einen Prozessor P, der derart eingerichtet ist, Schritte des erfindungsgemäßen Verfahrens, wie beispielhaft anhand der Figuren 1 und 2 beschrieben, auszuführen. Die Vorrichtung 100 ist somit derart eingerichtet, ein computergestütztes Bauwerksmodell BIM und erste Sensordaten D1 von mindestens einem realen Sensor einzulesen. Vorzugsweise umfasst die Vorrichtung eine Einheit 101 zum Selektieren mindestens eines Teils des Bauwerks anhand des computergestützten Bauwerksmodells BIM. Für diesen selektierten Teil des Bauwerks wird, in Abhängigkeit der ersten Sensordaten D1, eine computergestützte Simulation SIM ausgeführt, um zweite Sensordaten D2 für den selektierten Teil des Bauwerks zu generieren. Die Vorrichtung 100 umfasst vorzugsweise weiter eine Einheit 102 zum Analysieren der ersten Sensordaten D1 und/oder der zweiten Sensordaten D2 hinsichtlich der Auslastung mindestens eines Teils des Bauwerks, um aus der Analyse mindestens eine Belegungsinformation BI für mindestens den Teil des Bauwerks abzuleiten. Die Vorrichtung 100 ist derart eingerichtet, die Belegungsinformation BI bereitzustellen und auszugeben, so dass daraus ein Belegungsplan BP generiert werden kann. Der generierte Belegungsplan kann beispielsweise an einen Nutzer über eine Benutzerschnittstelle (GUI), wie z.B. eine graphische Benutzerschnittstelle oder -oberfläche, ausgegeben werden. Beispielsweise kann der Belegungsplan interaktiv für einen Nutzer visualisiert werden, um eine aktuelle orts- und zeitabhängige Belegung abzubilden. Auf Basis des zeitabhängigen Belegungsplans und/oder mehrerer, zeitabhängiger Belegungspläne können weitere Analysen durchgeführt werden, wie z.B. Ermittlung der aktuellen Personenanzahl eines Raums oder eines Stockwerks zu einem vorgegebenen Zeitpunkt oder Zeitraum. Außerdem kann anhand des Belegungsplans die Gebäudetechnik optimal gesteuert werden, wie z.B. durch einen Abgleich einer aktuellen Belegung mit der Temperatur- oder Beleuchtungsregulierung.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Computerimplementiertes Verfahren zur Generierung eines Belegungsplans (BP) für ein Bauwerk (B), umfassend die Verfahrensschritte:
- Einlesen (S1) eines computergestützten Bauwerksmodells (BIM) des Bauwerks,
- Einlesen (S2) erster Sensordaten (D1) mindestens eines Sensors, wobei die ersten Sensordaten (D1) eine zeit- und/oder positionsabhängige Auslastungsinformation in Bezug auf mindestens einen Teil des Bauwerks umfassen,
- Selektieren (S3) mindestens eines weiteren Teils des Bauwerks anhand des computergestützten Bauwerksmodells (BIM),
- Generieren (S4) zweiter Sensordaten (D2) mittels einer computergestützten Simulation (SIM) für den selektierten Teil des Bauwerks, wobei die zweiten Sensordaten (D2) eine zeit- und/oder positionsabhängige Auslastungsinformation in Bezug auf den selektierten Teil des Bauwerks umfassen,
- Ableiten (S5) einer Belegungsinformation (BI) für den jeweiligen Teil des Bauwerks für ein vorgegebenes Zeitintervall oder einen vorgegebenen Zeitpunkt aus einer Analyse der ersten Sensordaten (D1) und/oder der zweiten Sensordaten (D2) hinsichtlich der jeweiligen Auslastungsinformation in dem vorgegebenen Zeitintervall oder zu dem vorgegebenen Zeitpunkt und
- Ausgeben (S6) der jeweiligen Belegungsinformation (BI) zur Generierung eines Belegungsplans (BP) für das Bauwerk.

2. Computerimplementiertes Verfahren nach Anspruch 1, wobei die computergestützte Simulation (SIM) auf Basis der ersten Sensordaten (D1) ausgeführt wird.

3. Computerimplementiertes Verfahren nach einem der vorhergehenden Ansprüche, wobei die computergestützte Simulation (SIM) eine computergestützte Personenstromsimulation für den selektierten Teil des Bauwerks ist.

4. Computerimplementiertes Verfahren nach einem der vorhergehenden Ansprüche, wobei der Belegungsplan (BP) auf Basis aktueller erster Sensordaten und zu einem vorgegebenen Zeitpunkt aktualisiert generiert wird.

5. Computerimplementiertes Verfahren nach einem der vorhergehenden Ansprüche, wobei die ersten Sensordaten (D1) mit einem dem mindestens einen Sensor zugeordneten Zuverlässigkeitswert gekennzeichnet werden.

6. Computerimplementiertes Verfahren nach einem der vorhergehenden Ansprüche, wobei für den mindestens einen weiteren selektierten Teil des Bauwerks eine Belegungsinformation (BI) mittels einer Plausibilitätsanalyse abgeleitet wird.

7. Computerimplementiertes Verfahren nach einem der vorhergehenden Ansprüche, wobei die ersten Sensordaten (D1) und/oder die zweiten Sensordaten (D2) zumindest teilweise in das computergestützte Bauwerksmodell (BIM) eingefügt werden (S7).

8. Computerimplementiertes Verfahren nach einem der vorhergehenden Ansprüche, wobei die jeweilige Belegungsinformation (BI) und/oder der Belegungsplan in das computergestützte Bauwerksmodell (BIM) eingefügt wird.

9. Computerimplementiertes Verfahren nach einem der vorhergehenden Ansprüche, wobei der generierte Belegungsplan (BP) an einen Nutzer zur Optimierung der Auslastung des Bauwerks und/oder zur Steuerung einer Gebäudetechnik in Abhängigkeit des Belegungsplans ausgegeben wird.

10. Vorrichtung (100) zur Generierung eines Belegungsplans (BP) für ein Bauwerk (B), umfassend mindestens einen Prozessor (P) zur Ausführung der Schritte des Verfahrens nach einem der Ansprüche 1 bis 9 auszuführen.

11. Computerprogrammprodukt umfassend Programmcodeteile, die bei der Ausführung des Programms durch einen Prozessor diesen veranlassen, die Schritte des Verfahrens nach einem der Ansprüche 1 bis 9 auszuführen.

12. Computerlesbarer Datenträger, auf dem das Computerprogrammprodukt nach Anspruch 11 gespeichert ist.
